# EUROPÄISCHE PATENTSCHRIFT

(11) **EP 4 507 463 B1**
(45) Veröffentlichungstag und Bekanntmachung des Hinweises auf die Patenterteilung: **04.02.2026**
(21) Anmeldenummer: 23189941.0
(22) Anmeldetag: 07.08.2023
(51) Int. Cl.: H05K 7/14, H05K 7/20, F28D 15/02, F28D 15/04, F28F 1/32

(54) **AUTOMATISIERUNGSGERÄT MIT KÜHLKÖRPER**
AUTOMATION DEVICE WITH COOLING BODY
APPAREIL D'AUTOMATISATION AVEC DISSIPATEUR THERMIQUE

(43) Veröffentlichungstag der Anmeldung: 12.02.2025
(73) Patentinhaber: Siemens Aktiengesellschaft, 80333 München (DE)
(72) Erfinder: Bergmann, Martin, 92253 Schnaittenbach (DE); Stein, Ulf, 92421 Schwandorf (DE)
(74) Vertreter: Siemens Patent Attorneys

(56) Entgegenhaltungen:
- EP-A1- 2 479 861
- EP-B1- 2 736 311
- DE-U1- 202009 004 656
- US-A1- 2005 224 214
- US-A1- 2011 073 283
- US-A1- 2022 346 274

## Beschreibung

Die Erfindung betrifft ein Automatisierungsgerät ausgestaltet für den Einsatz in einem Automatisierungsumfeld zur Automatisierung eines industriellen Prozesses, aufweisend ein Grundgehäuse umfassend eine Rückseite eine Oberseite, eine Unterseite, ein erstes Seitenteil und ein zweites Seitenteil, wodurch eine Kastenform gegeben ist, die Rückseite ist zur Montage an einem Montagemittel ausgestaltet, eine Leiterplatte ist parallel zu dem ersten Seitenteil und dem zweiten Seitenteil rechtwinklig zu der Oberseite bzw. der Unterseite angeordnet, die Leiterplatte trägt einen Mikroprozessor, welcher wiederum mit einem Kühlkörper in thermischer Verbindung steht, wobei der Kühlkörper Kühlbleche aufweist.

Die EP 2 736 311 B1 offenbart ein Automatisierungsgerät aufweisend ein Grundgehäuse, eine Fronthaube, einen Hauptkühlkörper zum Abführen von Wärme eines Mikroprozessors.

Aufgrund einer Miniaturisierung von Elektronikkomponenten, wird zunehmend eine höhere Packungsdichte/Funktionsdichte an elektronischen Komponenten/Bauteilen auf einer Flachbaugruppe, wie beispielsweise einer bestückten Leiterplatte, realisiert. Dies führt zu einer Erhöhung der Verlustleistung, insbesondere bei Mikroprozessoren, da die Leistungsfähigkeit von Mikroprozessoren zunehmend steigt und damit auch eine Verlustwärme steigt. Der Einsatz von beispielsweise modernen Mikroprozessoren, wie sie für die Personal Computer Welt eingesetzt werden, in einem Automatisierungsgerät führt zu einem enormen Anstieg der Verlustleistung in dem Automatisierungsgerät.

Bei üblichen, bisherigen CPUen im gesamten Industriebereich wurden bisher Prozessoren mit geringerer Leistungsdichte verbaut. Daher waren als "State of the Art" bisher Kühlkörper aus Druckguss- oder Strangpressteilen ausreichend. Durch die wesentlich höhere Leistungsdichte der neuen Prozessor-Generationen wäre ein solcher Kühlkörper, bei den in der Industrie geforderten Umgebungsbedingungen, wie beispielsweise Temperaturen bis 60°C, keine aktiven Lüfter nutzen, sondern nur auf Konvektions-Kühlung zurückzugreifen, Schwing- und Schock-Beanspruchung und sehr langer Dauerbetrieb bis zu 10 Jahren, durch seine geringere Kühlleistung nicht ausreichend. Daher muss hier zukünftig ein neuartiges, wesentlich leistungsfähigeres Kühlsystem eingesetzt werden. Weiterhin soll eine ausreichende Kühlung unabhängig von einer Einbaulage gewährleistet sein.

Die EP 2 479 861 A1 beschreibt ein Automatisierungsgerät mit einem Lagesensor, der die Einbaulage des Geräts erkennt (z. B. horizontal oder vertikal), bei zu hoher Temperatur und ungünstiger Einbaulage, wird die Leistung reduziert.

Die US 2005/0224214 A1 beschreibt ein Kühlsystem für elektronische Baugruppen, das auf einer Kombination aus Wärmeableitung und Luftstrom basiert. Jede Lamelle verfügt über eine Öffnung, die einen Luftstrom durch die Lamellen ermöglicht. Die Öffnungen sind so gestaltet, dass ihr Durchmesser mit zunehmender Entfernung von der Basisplatte abnimmt, was die Effizienz der Wärmeübertragung verbessert.

In der US 2022/0346274 A1 wird eine enge thermische Verbindung zwischen Kühl-Rippen und einem Wärmerohr beschrieben, wodurch eine Wärmeübertragung beschleunigt wird.

Es ist eine Aufgabe der vorliegenden Erfindung ein verbessertes Kühlkonzept für Automatisierungsgeräte bereitzustellen, welches eine ausreichende Kühlung unabhängig von einer Einbaulage gewährleistet.

Die Aufgabe wird dadurch gelöst, dass der Kühlkörper eine Mehrzahl an Kühlblechen aufweist, welche parallel zur Leiterplatte mit jeweils einem Zwischenraum zueinander angeordnet sind und somit für eine erste Einbaulage, in welcher die Unterseite waagerecht ausgerichtet ist, es einem Kühlmedium möglich ist von der Unterseite durch die Zwischenräume zu strömen, wobei in den Kühlblechen jeweils Öffnungen angeordnet sind und somit für eine zweite Einbaulage, in welcher die Unterseite vertikal ausgerichtet ist, es dem Kühlmedium möglich ist durch die in der zweiten Einbaulage übereinander angeordneten Öffnungen zu strömen.

Die in den Kühlblechen eingebrachten Öffnungen wirken innerhalb eines Kühlkörper-Paketes ähnlich wie ein Kamin. Aufgewärmte Luft kann gemäß dem Bernoulli Effekt gut abströmen. Die Rückseite ist zur Montage an einem Montagemittel zum Beispiel einer Schalttafel oder auf einer Standard-Hutschiene ausgestaltet. Eine übliche erste Einbaulage ist eine waagerechte Einbaulage, aber in einigen Fällen kann aufgrund von Platzmangel eine zweite Einbaulage, also eine um 90°C zur ersten Einbaulage gedrehte Einbaulage gefordert sein. Beispielsweise ist der Temperaturbereich für Automatisierungsbaugruppen von 0°C bis +60°C ausgelegt, aber bei einer senkrechten Einbaulage sollten 40°C nicht überschritten werden.

Die Kühlleistung wird weiter optimiert, wenn die Öffnungen in dem Kühlblech als Flügel aus dem Kühlblech herausgebogen sind. Die Öffnungen ergeben insbesondere mit nach oben geklappten Flügeln eine noch gleichmäßigere, laminare Strömung. Dieser Effekt wirkt sich nochmals positiv auf den Wirkungsgrad einer evtl. eingesetzten Heatpipe im vertikalen Fall aus. Weiterhin haben diese Flügel den Vorteil, dass die Gesamtoberfläche der Kühlbleche fast identisch gegenüber der Gesamtoberfläche von einem Paket mit Kühlblechen ohne diese Öffnungen ist. Eine positive Folge daraus ist, dass eine Kühl-Performance bei Einsatz einer Heatpipe auch im waagerechten Einbau nahezu konstant bleibt.

Wird eine Heatpipe eingesetzt umfasst der Kühlkörper eine Kühlplatte, welche auf dem Mikroprozessor angeordnet ist, in die Kühlplatte ist eine Röhre derart eingelassen, dass ein erster Röhrenabschnitt senkrecht aus der Kühlplatte heraussteht, ein zweiter Röhrenabschnitt zumindest teilweise in die Kühlplatte eingelassen ist und ein dritter Röhrenabschnitt wiederum senkrecht aus der Kühlplatte heraussteht, die Kühlbleche sind am ersten Röhrenabschnitt und am dritten Röhrenabschnitt parallel zur Leiterplatte mit jeweils einem Zwischenraum zueinander angeordnet.

Die Kühlleistung wird noch weiter verbessert, wenn in die Kühlplatte eine erste Röhre und eine zweite Röhre derart eingelassen sind, dass ein erster Röhrenabschnitt der ersten Röhre senkrecht aus der Kühlplatte heraussteht, ein zweiter Röhrenabschnitt der ersten Röhre zumindest teilweise in die Kühlplatte eingelassen ist und ein dritter Röhrenabschnitt der ersten Röhre wiederum senkrecht aus der Kühlplatte heraussteht, und
dass ein erster Röhrenabschnitt der zweiten Röhre senkrecht aus der Kühlplatte heraussteht, ein zweiter Röhrenabschnitt der zweiten Röhre zumindest teilweise in die Kühlplatte eingelassen ist und ein dritter Röhrenabschnitt der zweiten Röhre wiederum senkrecht aus der Kühlplatte heraussteht, die Kühlbleche sind am ersten Röhrenabschnitt und am dritten Röhrenabschnitt der jeweiligen ersten und zweiten Röhre parallel zur Leiterplatte mit jeweils einem Zwischenraum zueinander angeordnet.

Es können zum Beispiel zwei Kupfer-Rohre, als sogenannte "Heatpipes" die in die Kühlplatte, welche als ein Heatspreader wirkt, entweder gepresst, geklebt oder gelötet werden. Die Kühlbleche beispielsweise aus Aluminium, können auch auf die Heatpipes entweder gepresst, geklebt oder gelötet werden.

Damit auch bei einer Vibrationsbeanspruchung des Automatisierungsgerätes der Kontakt des zu kühlenden Microprozessors zur Kühlplatte nicht verloren geht ist die Kühlplatte von einem Basisträger umgeben, an dem Basisträger ist ein Deckel angeordnet und zwischen dem Basisträger und dem Deckel ist die Leiterplatte angeordnet, wobei zwischen Deckel und Leiterplatte ein federnd gelagertes Anpressmittel angeordnet ist.

Um eine stabile Anordnung eines Kühlpaketes zu erhalten sind die Kühlbleche als Blechstanzteile ausgestaltet und im Randbereich sind Verbindungslaschen angeordnet, wobei eine Verbindungslasche ein Stützteil, einen ersten Schenkel und einen zweiten Schenkel umfasst, der erste Schenkel und der zweite Schenkel sind am Rand des Kühlblechs angeordnet, wobei sich der erste und zweite Schenkel zu dem Stützteil vereinigen, zwischen dem ersten Schenkel und dem zweiten Schenkel ist eine Ausnehmung derart ausgestanzt, das ein Zapfen am Rand angeordnet ist, wobei zusätzlich durch die Ausnehmung an der Verbindungsstelle des ersten und zweiten Schenkels zu dem Stützteil ein Zapfenlager angeordnet ist. Die Verbindungslaschen sind um 90 Grad zur Flächennormalen des Kühlbleches abgewinkelt, so wird es möglich ein Paket aus Kühlblechen zu bilden. Die Kühlbleche sind jetzt stapelbar und verklemmen bzw. verrasten miteinander.

Im Sinne der Erfindung ist unter Heatpipe also den eingesetzten Röhren ein Kühlungssystem zu verstehen, dass in Form eines geschlossenen Systems in Wärmerohren die Kühlung eines Microprozessors bewirkt. Die meisten Heatpipes funktionieren nach einem einfachen Schema: Das dünnwandige Wärmerohr besitzt innen eine spezielle Kapillarstruktur und ist aus thermisch hochleitfähigem Material hergestellt. Es verfügt über eine kleine Menge verdampfbarer Flüssigkeit. Durch das Prinzip der Röhrenkühlung nimmt eine Heatpipe höhere Temperaturen auf und transportiert diese an eine Stelle, an der es die Wärme abbauen kann.

Im Inneren des Wärmerohrs herrscht Unterdruck und es befindet sich etwas Flüssigkeit. Diese nimmt die Wärme auf, erhitzt sich und wandert in Dampfform an das andere Ende des Heat-pipes. Dabei wird sie aufgrund der dort herrschenden niedrigen Temperatur abkühlt und somit kondensiert. Hierdurch wird die Wärme abgegeben, wobei die Flüssigkeit wieder kalt wird.

Anschließend fließt sie wieder an ihrem eigentlichen Ort für die Wärmeaufnahme zurück und macht sich für eine neue Runde startbereit.

Die Zeichnung zeigt ein Ausführungsbeispiel der Erfindung. Dabei zeigt:
- FIG 1: ein Automatisierungsgerät in einer dreidimensionalen Ansicht,
- FIG 2: das Automatisierungsgerät mit Blick auf eine Vorderseite,
- FIG 3: das Automatisierungsgerät aus FIG 2 in einer um 90 Grad gedrehten Einbaulage,
- FIG 4: das Automatisierungsgerät mit Blick auf eine Seitenansicht,
- FIG 5: das Automatisierungsgerät mit einem teilgeöffneten Gehäuse mit Blick auf einen Kühlkörper,
- FIG 6: das Automatisierungsgerät mit Blick auf eine Leiterplatte und einen Mikroprozessor,
- FIG 7: eine Kühlkörpereinheit mit einem Kühlblechpaket,
- FIG 8: ein Kühlblech,
- FIG 9: die Kühleinheit mit Blick auf eine Kühlplatte und eine Darstellung von Heatpipes,
- FIG 10: die Kühleinheit aus FIG 9 in einer gedrehten Darstellung mit Blick auf einen Deckel,
- FIG 11: die Kühleinheit mit geöffnetem Deckel mit Blick auf ein Anpresselement,
- FIG 12: ein Anpresselement,
- FIG 13A, FIG13B: das Kühlblechpaket für das Automatisierungsgerät einmal in einer waagerechten Einbaulage und einmal in einer senkrechten Einbaulage,
- FIG 14: eine Detaildarstellung der Kühlbleche mit ineinandergehakten Verbindungslaschen und
- FIG 15: eine Detaildarstellung einer Verbindungslasche.

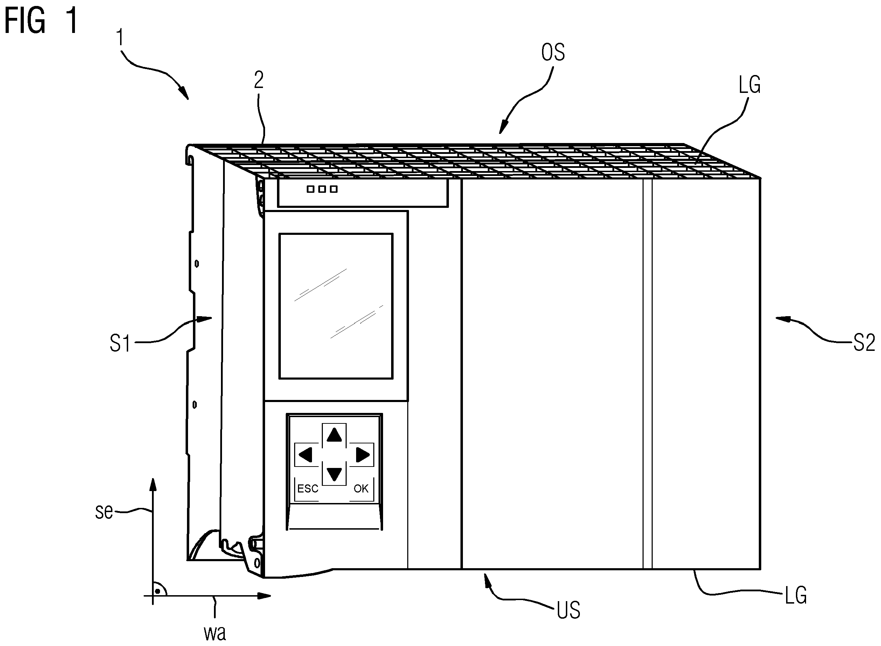

Gemäß FIG 1 ist ein Automatisierungsgerät 1 für den Einsatz in einem Automatisierungsumfeld zur Automatisierung eines industriellen Prozesses dargestellt.

Das Automatisierungsgerät 1 weist ein Grundgehäuse 2 umfassend eine Rückseite RS, eine Oberseite OS, eine Unterseite US, ein erstes Seitenteil S1 und ein zweites Seitenteil S2 auf. Dadurch ist für das Automatisierungsgerät 1 eine Kastenform gegeben, in welcher die im Inneren befindlichen elektronischen Schaltungen, Leiterplatte, Kühlelemente, Anschlüsse usw. angeordnet sind. Auf der Oberseite OS und der Unterseite US weist das Automatisierungsgerät 1 Lüftungsgitter LG auf. Für eine Standardeinbaulage ist das Automatisierungsgerät 1 waagerecht WA ausgerichtet. Das bedeutet, die Seitenteile S1,S2 sind senkrecht ausgerichtet. Das Automatisierungsgerät 1 ist hinsichtlich seines Kühlprinzips auf eine Konvektions-kühlung ausgelegt, das bedeutet, dass von der Unterseite US her Luft einströmen kann, die Baugruppe kühlen kann und an der Oberseite OS über das Lüftungsgitter LG wiederum austritt.

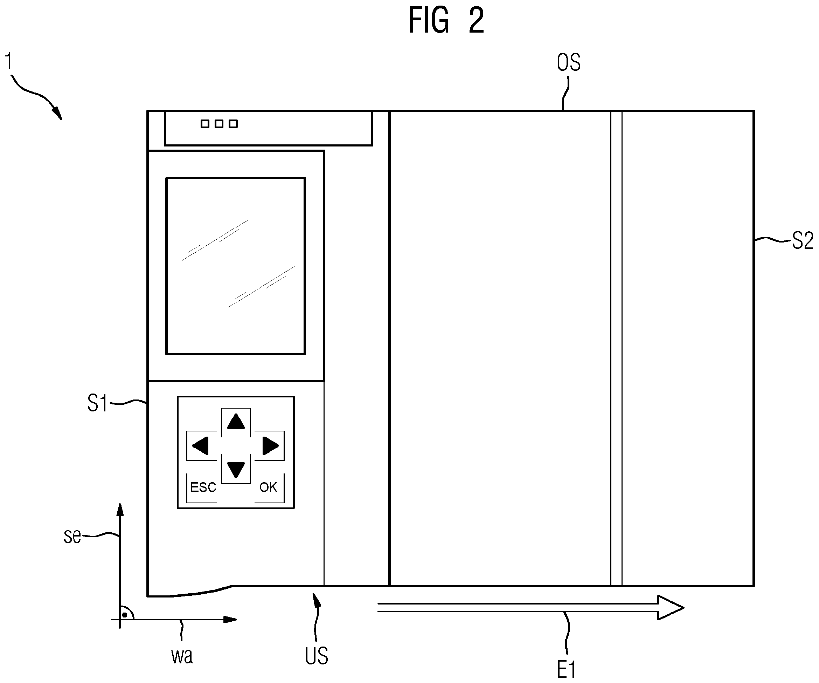

Die FIG 2 zeigt das Automatisierungsgerät 1 in einer ersten Einbaulage E1, die erste Einbaulage E1 ist für das Automatisierungsgerät 1 eine Vorzugseinbaulage. Die Unterseite US ist waagerecht WA ausgerichtet.

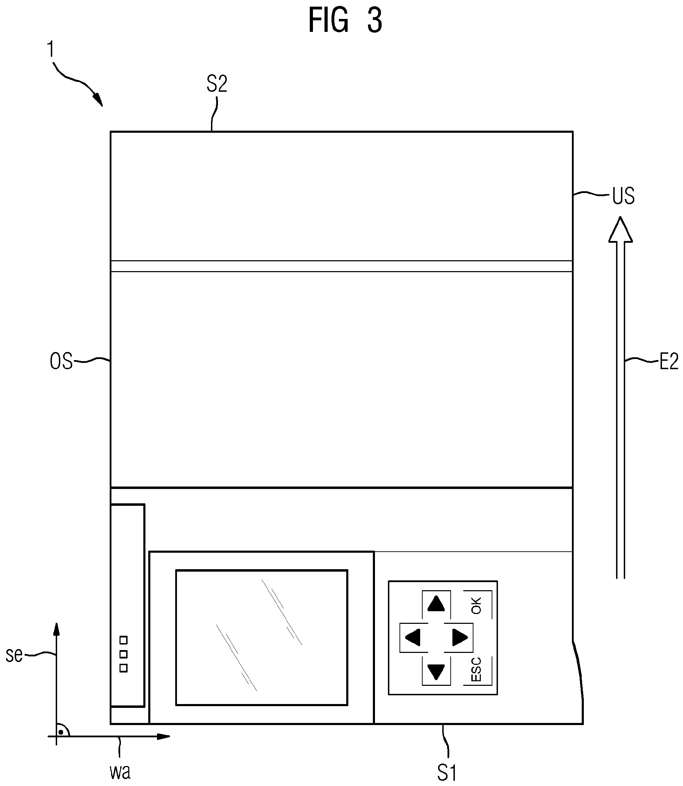

Die FIG 3 zeigt das Automatisierungsgerät 1 in einer zweiten Einbaulage E2 dabei sind die Seitenteile S1,S2 waagerecht WA und die Oberseite OS bzw. die Unterseite US sind senkrecht SE ausgerichtet.

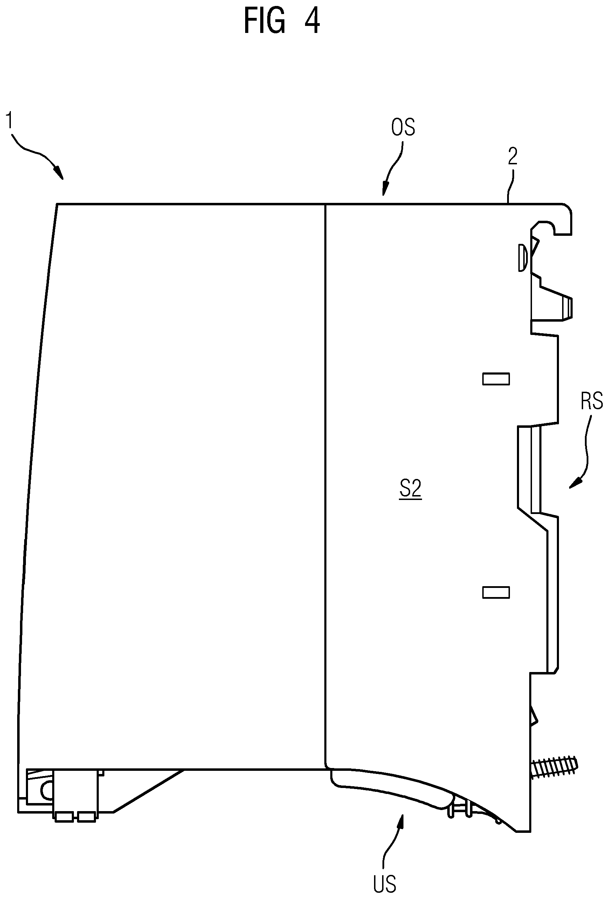

Gemäß FIG 4 ist das Automatisierungsgerät 1 mit Blick auf das zweite Seitenteil S2 dargestellt. Die Rückseite RS ist zur Montage an einem Montagemittel ausgestaltet. Hier befinden sich beispielsweise ein Haken um das Automatisierungsgerät 1 auf einer Profilschiene aufzuhaken, es befindet sich eine Massefeder um einen Massekontakt zur Profilschiene herzustellen und es befindet sich ein Schraubmittel für eine endgültige Befestigung.

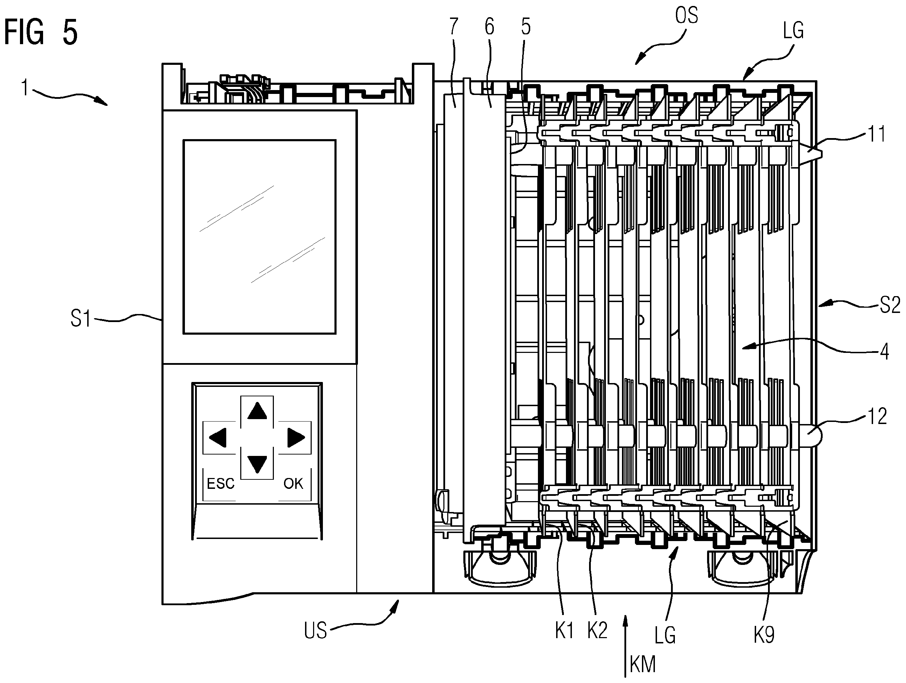

Gemäß FIG 5 ist das Automatisierungsgerät 1 teilweise von einer Fronthaube befreit und man erhält Blick auf einen Kühlkörper 4. Der Kühlkörper 4 steht in thermischer Verbindung mit einen auf einer Leiterplatte L angeordneten Mikroprozessor 3. Der Kühlkörper 4 weist eine Mehrzahl an Kühlblechen K1,...,K9 auf. Die Kühlbleche K1,...,K9 sind parallel zur Leiterplatte L mit jeweils einem Zwischenraum zueinander angeordnet und somit für die erste Einbaulage E1, in welcher die Unterseite US waagerecht WA ausgerichtet ist, es einen Kühlmedium KM möglich ist, von der Unterseite US durch die Zwischenräume zu strömen und das Automatisierungsgerät 1 zu entwärmen. In dem Kühlkörper 4 ist zur effektiven Entwärmung der Kühlplatte 5, welche direkt auf den Mikroprozessor 3 aufliegt, eine Heatpipe vorgesehen. Die Heatpipe umfasst eine erste Röhre 11 und eine zweite Röhre 12.

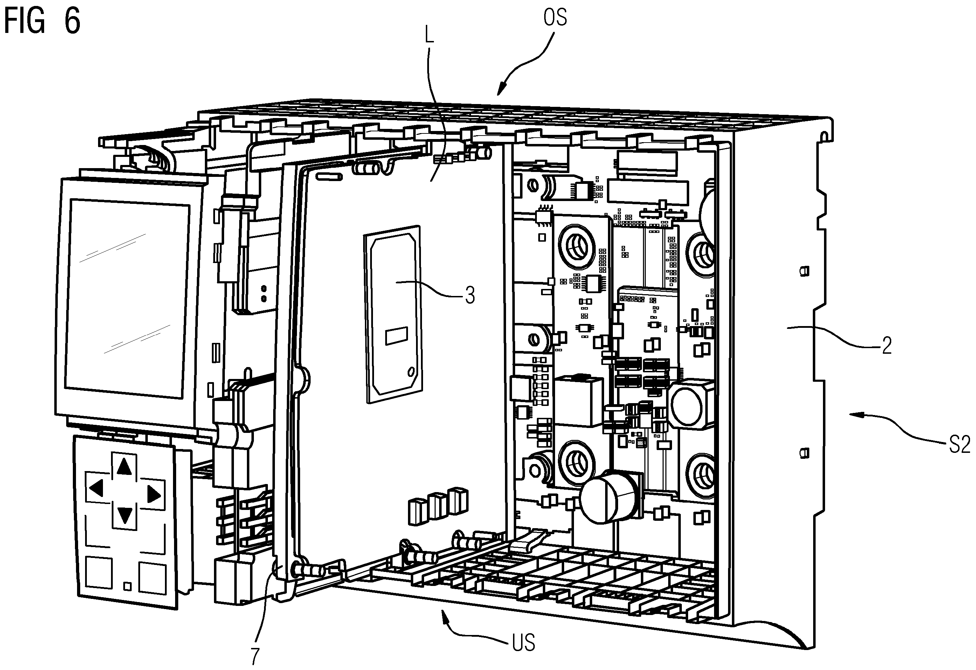

Dabei zeigt die FIG 6 das Automatisierungsgerät 1 in einer dreidimensionalen Ansicht mit entferntem Kühlkörper 4. Damit wird der Blick auf die Leiterplatte L und dem darauf verbauten Mikroprozessor 3 offengelegt. Bei herkömmlichen Prozessoren betrug bisher die Verlustleistung 5 bis 12 Watt. Nun sollen aber neue Prozessoren nach einem 10 nm-Herstellungsprozess zum Einsatz kommen. Diese Mikroprozessoren erreichen eine wesentlich höhere Taktfrequenz und damit auch eine wesentlich höhere Verlustleistung, welche effektiv abgeführt werden muss. Ein neuartiger Mikroprozessor 3 erreicht beispielsweise bei einem Turbofrequenzbetrieb eine Verlustleistung von nahezu 50 Watt.

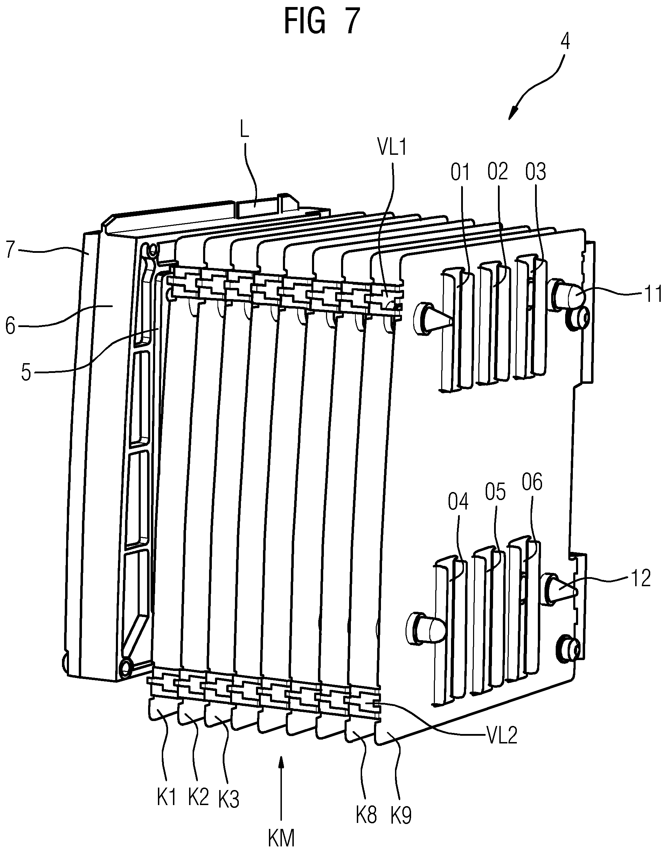

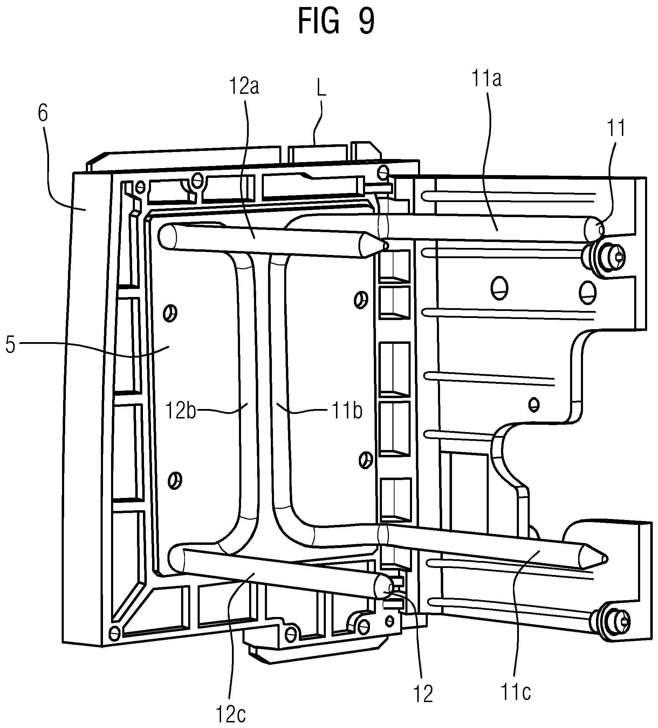

Gemäß FIG 7 ist der Kühlkörper 4 in einer dreidimensionalen Ansicht dargestellt. Der Kühlkörper 4 ist auf der Kühlplatte 5 angeordnet. Die Kühlplatte 5 ist wiederum direkt auf dem Mikroprozessor 3 angeordnet. In die Kühlplatte 5 ist eine erste Röhre 11 und eine zweite Röhre 12 (siehe FIG 9) angeordnet. Der Kühlkörper 4 umfasst eine Mehrzahl von Kühlblechen K1,...,K9, welche parallel zur Leiterplatte L jeweils mit einem Zwischenraum zueinander angeordnet sind und somit es einem Kühlmedium KM möglich ist, von der Unterseite US zwischen die Kühlbleche K1,...,K9 einzuströmen. In den Kühlblechen K1,...,K9 sind jeweils Öffnungen O1,...,O6 angeordnet und somit ist es möglich, für eine weitere zweite Einbaulage E2, in welcher die Unterseite US vertikal ausgerichtet ist, es dem Kühlmedium KM möglich ist, durch die übereinander angeordneten Öffnungen O1,...,O6 der einzelnen Kühlbleche K1,...,K9 zu strömen. Am Beispiel des neunten Kühlbleches K9 sind in einer ersten Reihe eine erste Öffnung O1, eine zweite Öffnung O2 und eine dritte Öffnung O3 angeordnet. In einer zweiten Reihe sind eine vierte Öffnung O4, eine fünfte Öffnung O5 und eine sechste Öffnung O6 angeordnet. Jedes Kühlblech K1,...,K9 weist diese Öffnungen O1,...,O6 auf, damit entsteht für eine senkrechte Einbaulage, nämlich die zweite Einbaulage E2, ein Kamin der das Kühlmedium KM nach oben durch die Öffnungen O1,...,O6 abführen kann.

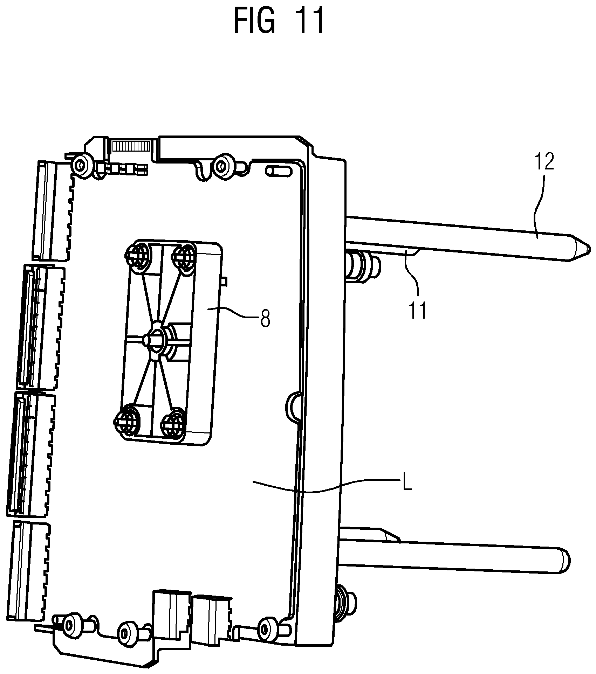

Die Kühlplatte 5 ist von einem Basisträger 6 umgeben. An dem Basisträger 6 ist ein Deckel 7 angeordnet und zwischen dem Basisträger 6 und dem Deckel 7 ist die Leiterplatte L angeordnet. Ein federgelagertes Anpressmittel 8 ist zwischen dem Deckel 7 und der Leiterplatte L angeordnet (siehe FIG 11).

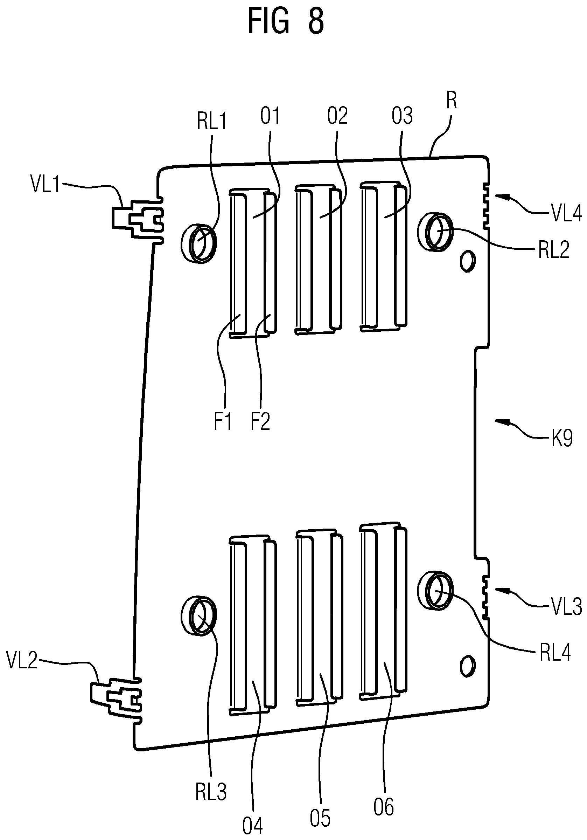

Gemäß FIG 8 ist ein einzelnes Kühlblech am Beispiel des neunten Kühlbleches K9 dargestellt. Die Öffnungen O1,...,O6 in dem neunten Kühlblech K9 sind als ein erster Flügel F1 und ein zweiter Flügel F2 aus dem neunten Kühlblech K9 herausgebogen. Für eine stapelbare Befestigung von mehreren Kühlblechen K1,...,K9 übereinander weist das neunte Kühlblech K9 eine erste Verbindungslasche VL1, eine zweite Verbindungslasche VL2, eine dritte Verbindungslasche VL3 und eine vierte Verbindungslasche VL4 auf. Das neunte Kühlblech K9 ist als ein Blechstanzteil aus Aluminium ausgestaltet und weist im Randbereich an dem Rand R die Verbindungslaschen VL1, ..., VL4 auf. Für das Aufstecken auf die erste Röhre 11 bzw. die zweite Röhre 12 weist das Kühlblech K9 ein erstes Rohrloch RL1, ein zweites Rohrloch RL2, ein drittes Rohrloch RL3 und ein viertes Rohrloch RL4 auf.

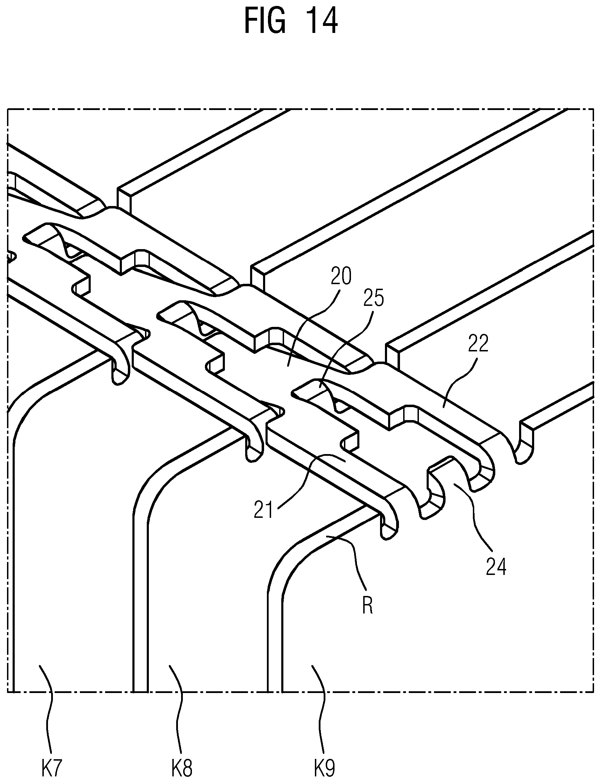

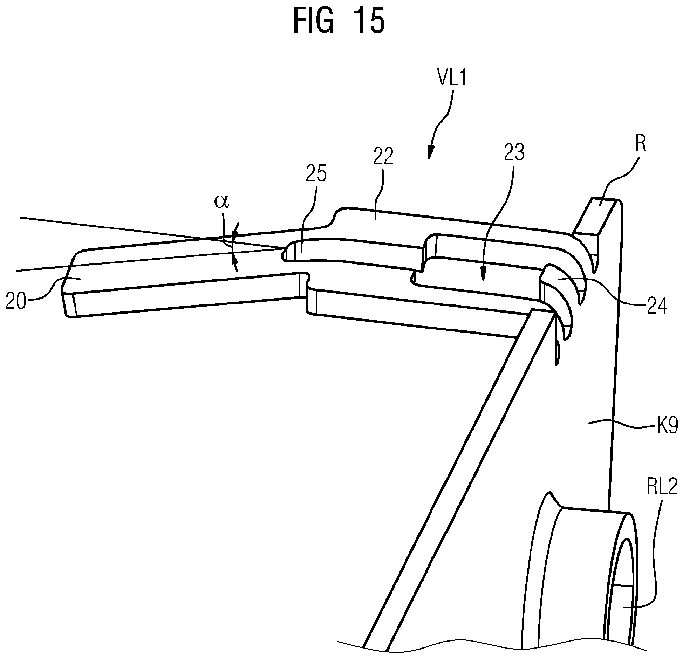

In den Figuren 14 und 15 werden später die Verbindungslaschen VL1,...,VL4 im Detail erklärt und es wird ersichtlich, wie aufgrund der Konstruktion der Verbindungslaschen VL1, ..., VL4 es möglich wird aus den einzelnen Kühlblechen K1,...,K9 einen stapelbaren fest miteinander verbundenen Kühlkörper 4 zu erstellen.

Mit der FIG 9 wird das Einlassen der ersten Röhre 11 und der zweiten Röhre 12 in die Kühlplatte 5 veranschaulicht. In die Kühlplatte 5 ist die erste Röhre 11 und die zweite Röhre 12 derart eingelassen, dass ein erster Röhrenabschnitt 11a der ersten Röhre 11 senkrecht aus der Kühlplatte 5 heraussteht. Ein zweiter Röhrenabschnitt 11b der ersten Röhre 11 ist zumindest teilweise in die Kühlplatte 5 eingelassen. Ein dritter Röhrenabschnitt 11c der ersten Röhre 11 steht wiederum senkrecht aus der Kühlplatte 5 heraus. Ebenso ist die zweite Röhre 12 angeordnet. Ein erster Röhrenabschnitt 12a der zweiten Röhre 12 steht senkrecht aus der Kühlplatte 5 heraus, ein zweiter Röhrenabschnitt 12b der zweiten Röhre 12 ist zumindest teilweise in die Kühlplatte 5 eingelassen. Ein dritter Röhrenabschnitt 12c der zweiten Röhre 12 steht wiederum senkrecht aus der Kühlplatte 5 heraus. Durch diese Anordnung der ersten Röhre 11 und der zweiten Röhre 12 können die Kühlbleche K1,...,K9 auf die senkrecht herausstehenden Röhrenabschnitte aufgestapelt werden und mit den Verbindungslaschen VL1, ..., VL4 miteinander zu einem Kühlkörperpaket verbunden werden.

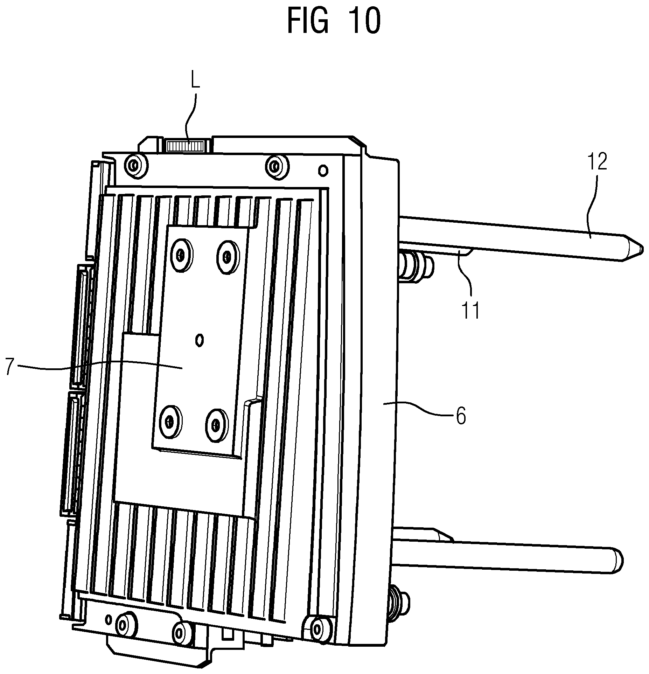

Die FIG 10 zeigt den auf den Basisträger 6 aufgeschraubten Deckel 7 unter der ausgeprägten Erhöhung im Deckel 7 befindet sich das Anpressmittel 8.

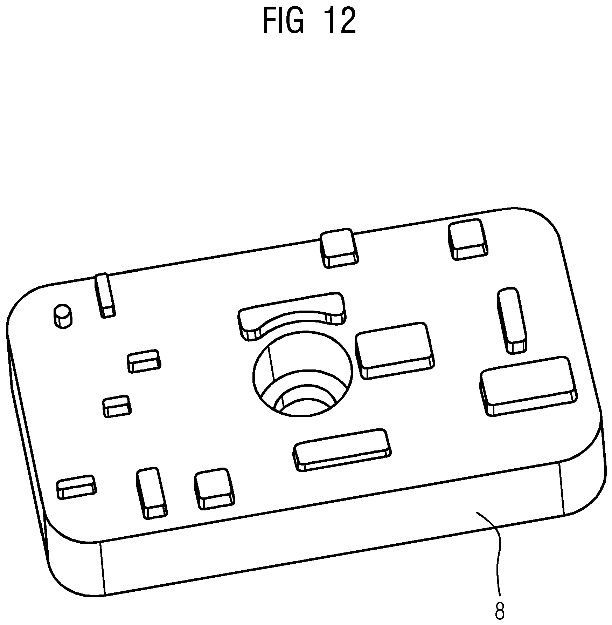

Mit der FIG 11 ist der Deckel 7 geöffnet und es wird das federnd gelagerte Anpressmittel 8 sichtbar. Das Anpressmittel 8 ist gemäß FIG 12 ausgestaltet, in dem Deckel 7 federnd gelagert die Leiterplatte über bestimmte angeordnete Dohme und Stege in dem Anpressmittel 8 gezielt auf die Kühlplatte 5 aufzudrücken, so dass der Mikroprozessor 3 immer guten Kontakt zur Kühlplatte 5 hat.

Das Anpressmittel 8 ist aus einem Kunststoff mit der Kurzbezeichnung PEEK 10GF, Polyetheretherketon mit 10%iger Glasfaserverstärkung, gefertigt. Dieser Werkstoff ermöglicht den Einsatz bei Dauergebrauchstemperaturen von bis zu 250-260°C.

Das Anpressmittel 8 ist als ein Andruckstempel mit speziell angeordneten Domen ausgestaltet. welche in die Lücken der Bestückung direkt auf die Leiterplatte L drücken. Dadurch wird die Leiterplatte L, mit auf der Gegenüberseite der Leiterplatte L bestückten Mikroprozessor 3, mit einer definierten Kraft von vier Andruckfedern auf die Kühlplatte 5 der Heatpipe gepresst, ohne elektronische Bauteile zu schädigen.

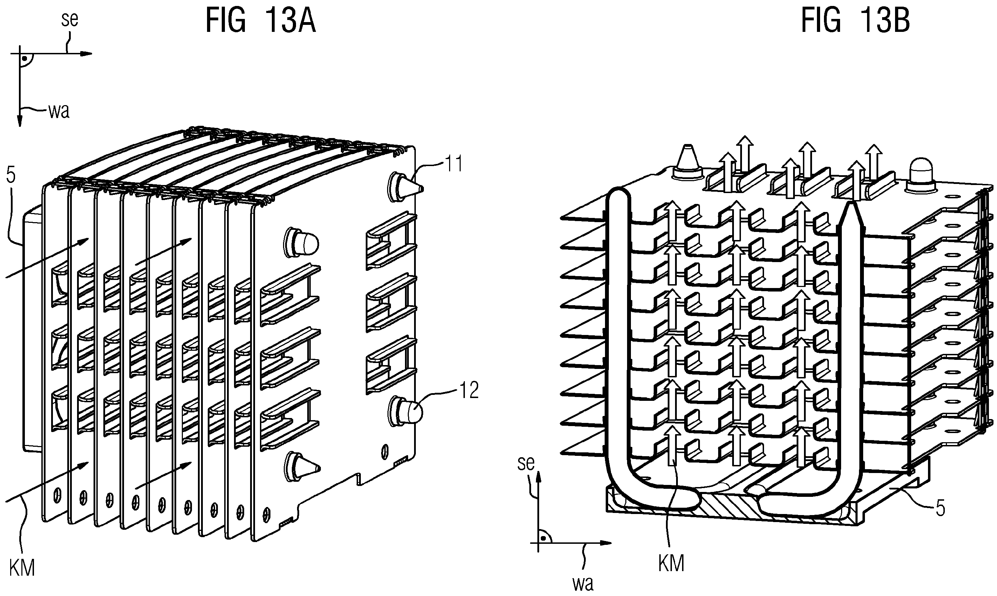

Die Figuren 13A und 13B verdeutlichen noch einmal das erfindungsgemäße Prinzip eines Kühlkörpers 4, welcher für eine erste Einbaulage E1 und eine zweite Einbaulage E2 die ausreichende Entwärmung der Baugruppe sicherstellt.

Gemäß FIG 13A kann in der ersten Einbaulage E1 ein Kühlmedium KM durch die Zwischenräume der Kühlbleche K1,...,K9 strömen. In der zweiten Einbaulage E2 gemäß FIG 13B befindet sich die Kühlplatte 5 in einer waagerechten WA Position. Jetzt ist es möglich, durch die übereinander angeordneten Öffnungen 01, ..., 06 dass das Kühlmedium KM durch eine Kaminwirkung durch den Kühlkörper 4 strömt. Durch die zusätzlich eingeführten als Flügel F1,F2 aus dem Kühlblech K1,...,K9 herausgebogenen Leitbleche, kann die Strömung noch einmal verbessert werden und es hat den besonderen Vorteil, dass die Oberfläche annähernd gleich groß bleibt wie bei einem nichtausgestanzten Kühlblech K1,...,K9.

Die FIG 14 und FIG 15 zeigen das konstruktive Prinzip der Verbindungslaschen VL1,...,VL4. Gemäß FIG 14 ist ein Detailausschnitt des Kühlkörpers 4 dargestellt. Das siebte Kühlblech K7 ist unter dem achten Kühlblech K8 und unter dem neunten Kühlblech K9 angeordnet. Im Randbereich am Rand R des neunten Kühlbleches K9 sind die Verbindungslaschen VL1, ..., VL4 aus dem Blechteil derart ausgestanzt, dass sich für eine Verbindungslasche VL1 folgende Anordnung ergibt. Ein Stützteil 20 ist mit einem ersten Schenkel 21 und einem zweiten Schenkel 22 verbunden. Der erste Schenkel 21 und der zweite Schenkel 22 sind am Rand R des Kühlbleches K1,...,K9 angeordnet. Der erste und zweite Schenkel 21,22 vereinigen sich zu dem Stützteil 20. Zwischen dem ersten Schenkel 21 und dem zweiten Schenkel 22 ist eine Ausnehmung derart ausgestanzt, dass ein Zapfen 24 am Rand R angeordnet ist. Das Gegenstück für den Zapfen 24 befindet sich zusätzlich durch die Ausnehmung 23 an der Verbindungsstelle des ersten und zweiten Schenkels 21,22 zu dem Stützteil 20 ist ein Zapfenlager 25 angeordnet. Ein jeweiliger Zapfen 24 des einzuhakenden Bleches greift in das Zapfenlager 25 des darüberliegenden Kühlbleches K1,...,K9 ein.

Das Stützteil 20 sorgt nicht nur für eine bessere Festigkeit sondern definiert den Abstand für die Zwischenräume zwischen den Kühlblechen K1,...,K9. Das Blechteil als ausgestanztes Aluminiumblechteil wird noch einmal mit FIG 15 verdeutlicht. Die ausgestanzte Verbindungslasche VL1 wird nahezu rechtwinklig von dem Kühlblech K9 abgebogen. Weiterhin ist das Stützteil 20 noch einmal um einen Biegewinkel α von dem ersten Schenkel 21 und dem zweiten Schenkel 22 abgebogen. Damit das Stützteil 20 auf dem darunterliegenden Kühlblech 20 sicher aufliegt. Das dargestellte zweite Rohrloch L2 ist mit einer Ausprägung auch durch einen Stanzvorgang aus dem Kühlblech K9 ausgestanzt. Durch diese Art der Ausstanzung lassen sich später die erste Röhre 11 bzw. die zweite Röhre 12 besser einkleben, verlöten oder verpressen.

Mit dargestellten Verbindungslaschen VL1,...,VL4 kann ein Kühlkörper 4 beliebig hoch gestapelt werden und hat immer eine ausreichende Festigkeit und erhält immer den gleichen Zwischenraum.

## Patentansprüche

1. Automatisierungsgerät (1) ausgestaltet für den Einsatz in einem Automatisierungsumfeld zur Automatisierung eines industriellen Prozesses, aufweisend
ein Grundgehäuse (2) umfassend eine Rückseite (RS) eine Oberseite (OS), eine Unterseite (US), ein erstes Seitenteil (S1) und ein zweites Seitenteil (S2), wodurch eine Kastenform gegeben ist, die Rückseite (RS) ist zur Montage an einem Montagemittel ausgestaltet, eine Leiterplatte (L) ist parallel zu dem ersten Seitenteil (S1) und dem zweiten Seitenteil (S2) rechtwinklig zu der Oberseite (OS) bzw. der Unterseite (US) angeordnet, die Leiterplatte (L) trägt einen Mikroprozessor (3), welcher wiederum mit einem Kühlkörper (4) in thermischer Verbindung steht, der Kühlkörper (4) weist Kühlbleche auf,
**dadurch gekennzeichnet, dass**
der Kühlkörper (4) eine Mehrzahl an Kühlblechen (K1,...,K9) aufweist, welche parallel zur Leiterplatte (L) mit jeweils einem Zwischenraum zueinander angeordnet sind und somit für eine erste Einbaulage (E1), in welcher die Unterseite (US) waagerecht ausgerichtet ist, es einem Kühlmedium (KM) möglich ist von der Unterseite (US) durch die Zwischenräume zu strömen, wobei in den Kühlblechen (K1,...,K9) jeweils Öffnungen (O1,...,O6) angeordnet sind und somit für eine zweite Einbaulage (E2), in welcher die Unterseite (US) vertikal ausgerichtet ist, es dem Kühlmedium (KM) möglich ist durch die übereinander angeordneten Öffnungen (O1,...,O6) zu strömen.

2. Automatisierungsgerät (1) nach Anspruch 1, wobei die Öffnungen (O1,...,O6) in dem Kühlblech (K1,...,K9) als Flügel (F1,F2) aus dem Kühlblech (K1,...,K9) herausgebogen sind.

3. Automatisierungsgerät (1) nach Anspruch 1 oder 2, wobei der Kühlkörper (4) eine Kühlplatte (5) umfasst, welche auf dem Mikroprozessor (3) angeordnet ist, in die Kühlplatte (5) ist eine Röhre derart eingelassen, dass ein erster Röhrenabschnitt (11a) senkrecht aus der Kühlplatte (5) heraussteht, ein zweiter Röhrenabschnitt (11b) zumindest teilweise in die Kühlplatte (5) eingelassen ist und ein dritter Röhrenabschnitt (11c) wiederum senkrecht aus der Kühlplatte (5) heraussteht, die Kühlbleche (K1,...,K9) sind am ersten Röhrenabschnitt (11a) und am dritten Röhrenabschnitt (11c) parallel zur Leiterplatte (L) mit jeweils einem Zwischenraum zueinander angeordnet.

4. Automatisierungsgerät (1) nach Anspruch 1 oder 2, wobei der Kühlkörper (4) eine Kühlplatte (5) umfasst, welche auf dem Mikroprozessor (3) angeordnet ist, in die Kühlplatte (5) ist eine erste Röhre (11) und eine zweite Röhre (12) derart eingelassen, dass ein erster Röhrenabschnitt (11a) der ersten Röhre (11) senkrecht aus der Kühlplatte (5) heraussteht, ein zweiter Röhrenabschnitt (11b) der ersten Röhre (11) zumindest teilweise in die Kühlplatte (5) eingelassen ist und ein dritter Röhrenabschnitt (11c) der ersten Röhre (11) wiederum senkrecht aus der Kühlplatte (5) heraussteht, und
dass ein erster Röhrenabschnitt (12a) der zweiten Röhre (12) senkrecht aus der Kühlplatte (5) heraussteht, ein zweiter Röhrenabschnitt (12b) der zweiten Röhre (12) zumindest teilweise in die Kühlplatte (5) eingelassen ist und ein dritter Röhrenabschnitt (12c) der zweiten Röhre (12) wiederum senkrecht aus der Kühlplatte (5) heraussteht, die Kühlbleche (K1,...,K9) sind am ersten Röhrenabschnitt (11a, 12a) und am dritten Röhrenabschnitt (11c,12c) der jeweiligen ersten und zweiten Röhre (11,12) parallel zur Leiterplatte (L) mit jeweils einem Zwischenraum zueinander angeordnet.

5. Automatisierungsgerät (1) nach einem der Ansprüche 3 oder **4,** wobei die Kühlplatte (5) von einem Basisträger (6) umgeben ist, an dem Basisträger (6) ist ein Deckel (7) angeordnet und zwischen dem Basisträger (6) und dem Deckel (7) ist die Leiterplatte (L) angeordnet, wobei zwischen Deckel (7) und Leiterplatte (L) ein federnd gelagertes Anpressmittel (8) angeordnet ist.

6. Automatisierungsgerät (1) nach einem der Ansprüche 1 bis 5, wobei die Kühlbleche (K2,...,K9) als Blechstanzteile ausgestaltet sind und im Randbereich Verbindungslaschen (VL1,...,VL4) angeordnet sind, wobei eine Verbindungslasche (Vl1) ein Stützteil (20), einen ersten Schenkel (21) und einen zweiten Schenkel (22) umfasst, der erste Schenkel (21) und der zweite Schenkel (22) sind am Rand (R) des Kühlblechs (K2,...,K9) angeordnet, wobei sich der erste und zweite Schenkel (21,22) zu dem Stützteil (20) vereinigen, zwischen dem ersten Schenkel (21) und dem zweiten Schenkel (22) ist eine Ausnehmung (23) derart ausgestanzt, dass ein Zapfen (24) am Rand (R) angeordnet ist, wobei zusätzlich durch die Ausnehmung (23) an der Verbindungsstelle des ersten und zweiten Schenkels (21,22) zu dem Stützteil (20) ein Zapfenlager (25) angeordnet ist.

## Claims

1. Automation device (1) embodied for use in an automation environment for the automation of an industrial process, which has
a basic enclosure (2) comprising a rear side (RS) an upper side (OS), an underside (US), a first side part (S1) and a second side part (S2), whereby a box shape is provided, the rear side (RS) is embodied for mounting on a mounting means, a printed circuit board (L) is arranged parallel to the first side part (S1) and the second side part (S2) at right angles to the upper side (OS) or the underside (US), the printed circuit board (L) carries a microprocessor (3), which in turn is in thermal connection with a heat sink (4), the heat sink (4) has cooling metal sheets,
**characterised in that**
the heat sink (4) has a plurality of cooling metal sheets (K1,...,K9) which are arranged parallel to the printed circuit board (L) in each case with a clearance between them and hence, for a first installation position (E1) in which the underside (US) is aligned horizontally, it is possible for a cooling medium (KM) to flow from the underside (US) through the clearances, wherein openings (01,...,06) are arranged in the cooling metal sheets (K1,...,K9) in each case and hence, for a second installation position (E2) in which the underside (US) is aligned vertically, it is possible for the cooling medium (KM) to flow through the openings (01,...,06) arranged one above the other.

2. Automation device (1) according to claim 1, wherein the openings (O1,...,O6) in the cooling metal sheet (K1,...,K9) are bent out of the cooling metal sheet (K1,...,K9) as vanes (F1,F2).

3. Automation device (1) according to claim 1 or 2, wherein the heat sink (4) comprises a cooling plate (5) which is arranged on the microprocessor (3), a pipe is embedded in the cooling plate (5) in such a way that a first pipe section (11a) protrudes vertically from the cooling plate (5), a second pipe section (11b) is at least partially embedded in the cooling plate (5) and a third pipe section (11c) in turn protrudes vertically from the cooling plate (5), the cooling metal sheets (K1,...,K9) are arranged on the first pipe section (11a) and on the third pipe section (11c) parallel to the printed circuit board (L) in each case with a clearance between them.

4. Automation device (1) according to claim 1 or 2, wherein the heat sink (4) comprises a cooling plate (5), which is arranged on the microprocessor (3), a first pipe (11) and a second pipe (12) are embedded in the cooling plate (5) in such a way that a first pipe section (11a) of the first pipe (11) protrudes vertically from the cooling plate (5), a second pipe section (11b) of the first pipe (11) is at least partially embedded in the cooling plate (5) and a third pipe section (11c) of the first pipe (11) in turn protrudes vertically from the cooling plate (5) and that a first pipe section (12a) of the second pipe (12) protrudes vertically from the cooling plate (5), a second pipe section (12b) of the second pipe (12) is at least partially embedded in the cooling plate (5) and a third pipe section (12c) of the second pipe (12) in turn protrudes vertically from the cooling plate (5), the cooling metal sheets (K1,...,K9) are arranged on the first pipe section (11a, 12a) and on the third pipe section (11c,12c) of the respective first and second pipe (11,12) parallel to the printed circuit board (L) in each case with a clearance between them.

5. Automation device (1) according to one of claims 3 or 4, wherein the cooling plate (5) is surrounded by a base support (6), a cover (7) is arranged on the base support (6) and the printed circuit board (L) is arranged between the base support (6) and the cover (7), wherein a spring-mounted pressing means (8) is arranged between the cover (7) and the printed circuit board (L).

6. The automation device (1) according to one of claims 1 to 5, wherein the cooling metal sheets (K2,...,K9) are embodied as sheet metal stampings and connecting tabs (VL1,...,VL4) are arranged in the edge region, wherein a connecting tab (Vl1) comprises a support part (20), a first limb (21) and a second limb (22), the first limb (21) and the second limb (22) are arranged at the edge (R) of the cooling metal sheet (K2,...,K9), wherein the first and second limb (21,22) are combined to form the support part (20), a recess (23) is stamped out between the first limb (21) and the second limb (22) such that a pin (24) is arranged on the edge (R), wherein a pin bearing (25) is additionally arranged through the recess (23) at the connection point of the first and second limb (21,22) to the support part (20).

## Revendications

1. Appareil (1) d'automatisation conformé pour être utilisé dans un environnement d'automatisation pour l'automatisation d'un processus industriel, comportant
un boîtier (2) de base comprenant une face (RS) arrière, une face (OS) supérieure, une face (US) inférieure, une première partie (S1) latérale et une deuxième partie (S2) latérale, grâce à quoi il y a une forme en caisson, la face (RS) arrière est conformée pour le montage sur un moyen de montage, une plaquette (L) à circuit imprimé est montée parallèlement à la première partie (S1) latérale et la deuxième partie (S2) latérale à angle droit avec la face (OS) supérieure et respectivement la face (US) inférieure, la plaquette (L) à circuit imprimé porte un microprocesseur (3), qui à son tour est en liaison thermique avec un dissipateur (4) thermique, le dissipateur (4) thermique a des tôles de refroidissement,
**caractérisé en ce que**
le dissipateur (4) thermique a une pluralité de tôles (K1, ..., K9) de refroidissement, qui sont disposées parallèlement à la plaquette (L) à circuit imprimé avec respectivement un espace intermédiaire entre elles et il est ainsi possible dans une première position (E1) de montage, dans laquelle la face (US) inférieure est dirigée horizontalement, à un fluide (KM) de refroidissement de passer dans les espaces intermédiaires à partir de la face (US) inférieure, dans lequel des ouvertures (O1, ..., 06) sont disposées respectivement dans les tôles (K1, ..., K9) de refroidissement et ainsi, dans une deuxième position (E2) de montage, dans laquelle la face (US) inférieure est dirigée verticalement, il est possible à un fluide (KM) de refroidissement de passer dans les ouvertures (O1, ..., O6) disposées les unes sur les autres.

2. Appareil (1) d'automatisation suivant la revendication 1, dans lequel les ouvertures (O1, ..., O6) dans la tôle (K1, ..., K9) de refroidissement sont incurvées sous la forme d'ailette (F1, F2) dans la tôle (K1, ..., K9) de refroidissement.

3. Appareil (1) d'automatisation suivant la revendication 1 ou 2, dans lequel le dissipateur (4) thermique comprend une plaque (5) de refroidissement, qui est disposée sur le microprocesseur (3), dans la plaque (5) de refroidissement, est encastré un tuyau, de manière à ce qu'un premier tronçon (11a) du tuyau sorte perpendiculairement de la plaque (5) de refroidissement, qu'un deuxième tronçon (11b) du tuyau soit encastré au moins en partie dans la plaque (5) de refroidissement et qu'un troisième tronçon (11c) du tuyau sorte à nouveau perpendiculairement de la plaque (5) de refroidissement, les tôles (K1, ..., K9) de refroidissement sont disposées, au premier tronçon (11a) de tuyau et au troisième tronçon (11c) de tuyau, parallèlement à la plaquette (L) à circuit imprimé avec respectivement un espace intermédiaire entre elles.

4. Appareil (1) d'automatisation suivant la revendication 1 ou 2, dans lequel le dissipateur (4) thermique comprend une plaque (5) de refroidissement, qui est disposée sur le microprocesseur (3), dans la plaque (5) de refroidissement est encastré un premier tuyau (11) et un deuxième tuyau (12), de manière à ce qu'un premier tronçon (11a) du premier tuyau (11) sorte perpendiculairement de la plaque (5) de refroidissement, qu'un deuxième tronçon (11b) du premier tuyau (11) soit encastré au moins en partie dans la plaque (5) de refroidissement et qu'un troisième tronçon (11c) du premier tuyau (11) sorte à nouveau perpendiculairement de la plaque (5) de refroidissement, et
en ce qu'un premier tronçon (12a) du deuxième tuyau (12) sorte perpendiculairement de la plaque (5) de refroidissement, qu'un deuxième tronçon (12b) du deuxième tuyau (12) soit encastré au moins en partie dans la plaque (5) de refroidissement et qu'un troisième tronçon (12c) du deuxième tuyau (12) sorte à nouveau perpendiculairement de la plaque (5) de refroidissement, les tôles (K1, ..., K9) de refroidissement sont disposées, aux premiers tronçons (11a, 12a) de tuyaux et aux troisièmes tronçons (11c, 12c) de tuyaux des premiers et deuxièmes tuyaux (11, 12) respectifs, parallèlement à la plaquette (L) à circuit imprimé avec respectivement un espace intermédiaire entre elles.

5. Appareil (1) d'automatisation suivant l'une des revendications 3 ou 4, dans lequel la plaque (5) de refroidissement est entourée d'un support (6) de base, un couvercle (7) est disposé sur le support (6) de base et la plaquette (L) à circuit imprimé est disposée entre le support (6) de base et le couvercle (7), dans lequel un moyen (8) d'application d'une pression monté élastiquement est disposé entre le couvercle (7) et la plaquette (L) à circuit imprimé.

6. Appareil (1) d'automatisation suivant l'une des revendications 1 à 5, dans lequel les tôles (K2, ..., K9) sont conformées en pièces de tôle découpées et, dans la zone de bord sont disposées des languettes (VL1, ..., VL4) de liaison, dans lequel une languette (V11) de liaison comprend une partie (20) d'appui, une première branche (21) et une deuxième branche (22), la première branche (21) et la deuxième branche (22) sont disposées au bord (R) de la tôle (K2, ..., K9) de refroidissement, dans lequel la première et la deuxième branches (21, 22) se réunissent en la partie (20) d'appui, un évidement (23) est poinçonné entre la première branche (21) et la deuxième branche (22), de manière à ce qu'un tenon (24) soit disposé au bord (R), dans lequel, supplémentairement par l'évidement (23), un support (25) de tenon est disposé au point de liaison de la première et de la deuxième branches (21, 22) à la partie (20) d'appui.
